# FASCICULE DE BREVET EUROPEEN

(11) **EP 0 721 588 B1**
(45) Date de publication et mention de la délivrance du brevet: **13.08.1997**
(21) Numéro de dépôt: 94928932.6
(22) Date de dépôt: 29.09.1994
(51) Int. Cl.: G01P 15/125, G01D 11/24

(54) **CAPTEUR ELECTRONIQUE INTEGRE DESTINE A LA CARACTERISATION DE GRANDEURS PHYSIQUES ET PROCEDE DE REALISATION D'UN TEL CAPTEUR**
INTEGRIERTER ELEKTRONISCHER SENSOR FÜR PHYSIKALISCHE GRÖSSEN UND HERSTELLUNGSVERFAHREN DAFÜR
BUILT-IN ELECTRONIC SENSOR FOR THE CHARACTERIZATION OF PHYSICAL QUANTITIES AND METHOD OF PRODUCTION

(30) Priorité: 30.09.1993 FR 9311672
(43) Date de publication de la demande: 17.07.1996
(73) Titulaire: COMMISSARIAT A L'ENERGIE ATOMIQUE, 75015 Paris (FR)
(72) Inventeur: CAILLAT, Patrice, F-38130 Echirolles (FR)
(74) Mandataire: Dubois-Chabert, Guy
(86) Numéro de dépôt international: FR9401141
(87) Numéro de publication internationale: WO9509367

(56) Documents cités:
- US-A- 4 930 043
- US-A- 5 164 328
- EDN ELECTRICAL DESIGN NEWS, vol.37, no.18, 3 Septembre 1992, NEWTON, MASSACHUSETTS US pages 69 - 76, XP310686 QUINELL 'silicon accelerometers tackle cost sensitive applications.

## Description

La présente invention a pour objet un capteur électronique intégré destiné à la caractérisation d'une grandeur physique comprenant un organe de caractérisation dont une partie est mobile.

L'invention s'applique en particulier dans le domaine de la microélectronique où le développement des techniques de micro-usinage permet la fabrication d'organes de caractérisation susceptibles de transformer des grandeurs comme l'accélération, la pression ou le flux, en effets électriques caractérisables par mesure ou acquisition de signaux de type tout ou rien.

Les capteurs de ce type comportent un organe de caractérisation mobile par rapport à un substrat qui en se déformant ou se déplaçant crée soit un potentiel électrique, soit provoque la modification de la valeur d'une capacité, d'une induction ou d'une résistance électriques. La modification de ces caractéristiques est exploitée par un circuit électronique de lecture associé au composant. Une illustration des technologies mises en oeuvre dans ces capteurs est donnée dans l'article "Low-cost integrated silicon sensors" de Fouad Rahali et al., 9th european Hybrid Microelectronics conference, pages 243 à 249.

Ces capteurs comportent de plus un capot qui a plusieurs fonctions ; il doit protéger l'organe de caractérisation des agressions de l'environnement et doit permettre son maintien notamment en cas de contraintes physiques dépassant les limites mécaniques de l'organe.

Dans un accéléromètre comportant une masse sismique susceptible de se déplacer sous l'effet d'une accélération, le capot sert de butée pour éviter un déplacement exagéré de la masse risquant de la détériorer.

Le document US-A-4 930 043 montre par ailleurs un accéléromètre dans lequel des butées en matériau isolant, prévues sur des plaques de capot, empêchent un organe de caractérisation de venir en contact électrique avec ces plaques.

En général, un espacement est prévu entre le capot et l'organe sensible de caractérisation pour éviter en fonctionnement normal le contact entre ces deux parties. Ainsi, le capot n'entrave pas le mouvement de l'organe de caractérisation et n'affecte pas le résultat des mesures. Un tel agencement est décrit dans le brevet US-A-A-5 164 328. Dans ce brevet, le capot est en outre cosntitué d'un substrat de circuit intégré.

Il est connu de ce document d'assembler le capot et le substrat comportant l'organe de caractérisation au moyen d'une technique d'interconnexion par billes de matériau fusible généralement désignée par la technique "Flip Chip".

Cette technique consiste à déposer sur l'une des parties à assembler des billes ou des galettes d'assemblage en matériau fusible et à porter les deux parties à assembler, mises face à face, à une température légèrement supérieure à la température de fusion du matériau des billes de manière à réaliser une sorte de brasage.

De préférence, on réalise préalablement sur les parties à assembler des plots d'interconnexion constituation une surface mouillante par rapport au matériau des billes ou galettes. Les plots respectivement de chaque partie à assembler sont disposés en regard les uns des autres et les billes ne sont déposées que sur les plots de l'une des parties.

L'assemblage du capot et du substrat comportant l'organe de caractérisation par la technique de "Flip-chip" est très intéressante car les billes d'interconnexion assurant la cohésion de la structure, permettent également un contact électrique lorsqu'elles sont conductrices. Une autre fonction essentielle des billes est de servir de billes afin de maintenir et de définir l'espacement prévu entre le capot et l'organe de caractérisation.

Malheureusement, cette solution est difficilement applicable dans nombre de capteurs.

En effet, en raison d'une miniaturisation des capteurs liée notamment à l'émergence de nouvelles technologies d'usinage (telles que les gravures) en surface, l'espacement entre le capot et l'organe sensible de caractérisation doit être très faible et surtout obtenu avec une très grande précision.

Par exemple, dans le cas d'un accéléromètre, un espacement de 2 à 5 µm est prévu entre le capot et la masse sismique.

Or, avec les techniques actuelles d'interconnexion par "Flip-chip" il est très difficile d'atteindre des espacements inférieurs à 15 µm avec une précision suffisante.

Par ailleurs, lorsque les billes d'interconnexion sont de petite taille pour réduire l'espacement entre le capot et l'organe de caractérisation, surviennent des problèmes de comportement thermomécanique.

Les coefficients de dilatation des parties interconnectées pouvant être différents, des contraintes importantes peuvent apparaître dans les billes sous l'effet d'une variation de température.

De même, lorsque le substrat et le capot sont de même nature, le capot comportant généralement un circuit de lecture, ce dernier chauffe en fonctionnement et il existe malgré tout des différences de dilatation entre le capot et le substrat.

La solution à ce problème consistant à augmenter la taille des billes va, dans le cas présent, à l'encontre du but recherché de la réduction de l'espacement entre l'organe de caractérisation et le capot.

L'invention a donc pour objet un capteur électronique et son procédé de fabrication permettant notamment de résoudre les problèmes ci-dessus.

Un but de l'invention est de réaliser un capteur dans lequel la distance entre le capot et l'organe de caractérisation est à la fois très faible et contrôlable avec une très grande précision.

Un autre but de l'invention est de réaliser une interconnexion entre le capot et l'organe de caractérisation qui présente une bonne tenue aux contraintes thermomécaniques et qui soit d'une mise en oeuvre très simple.

A cet effet, l'invention se rapporte à un capteur électronique intégré destiné à la caractérisation d'une grandeur physique, comprenant un substrat comportant un organe de caractérisation dont une partie est apte à se déformer selon au moins une direction, et un capot maintenu à proximité et face à l'organe de caractérisation au moyen d'au moins une bille en matériau fusible solidaire du substrat et de hauteur adaptée aux contraintes thermomécaniques du capteur, un premier espacement étant ainsi ménagé entre le capot et le substrat, caractérisé en ce que le capot comporte un bossage d'épaisseur contrôlée en regard de l'organe de caractérisation de manière à définir un second espacement entre le capot et l'organe plus petit que l'espacement entre le capot et le substrat.

Ce bossage dont l'épaisseur peut être contrôlée de manière simple et précise permet d'ajuster avec une précision très grande la distance libre du capot jusqu'à l'organe de caractérisation.

Le bossage sert également à éviter une déformation ou un déplacement excessif de l'organe de caractérisation ou de la partie mobile de cet organe. A cette fin, le bossage présente une surface de butée contre laquelle l'organe de caractérisation vient s'appuyer lorsqu'il est soumis à une contrainte excessive.

De manière générale, le second espacement entre le capot et l'organe de caractérisation est au maximum égal à la course autorisée avant rupture de l'organe de caractérisation.

En outre, le bossage peut servir à protéger la partie mobile de l'organe de caractérisation en lui interdisant un déplacement selon une direction ne correspondant pas à la direction de déplacement prévue. A cet effet, la surface du bossage en regard de l'organe de caractérisation est avantageusement orientée parallèlement à la direction de déplacement de la partie mobile de l'organe de caractérisation.

Le bossage sera au minimum de la taille de la partie mobile à laquelle il fait face. Il pourra éventuellement être lui-même usiné pour répondre à certains critères géométriques de ladite partie mobile. En particulier, le bossage peut être gravé selon la même géométrie que la partie mobile (par exemple en peigne). Il pourra être réalisé en matériau isolant ou en matériau conducteur si on souhaite l'utiliser comme deuxième électrode d'un circuit électrique, la partie mobile formant alors la première électrode.

Dans le cas notamment des caractérisations en tout ou rien, le bossage est réalisé en un matériau électriquement conducteur. Le bossage peut aussi ne comporter qu'une partie en un matériau électriquement conducteur, la partie formant alors la surface de butée. Le matériau conducteur peut être par exemple de l'aluminium.

Ce cas particulier où le bossage est conducteur peut permettre également de réaliser un capteur sensible selon trois directions : les directions x et y parallèles à la surface du substrat du capteur comme les capteurs classiques décrits précédemment et la direction z perpendiculaire à la surface du substrat du capteur, par contact électrique entre la partie mobile et le bossage ou par modification de la capacité entre ces deux conducteurs. Un tel capteur peut s'appliquer en particulier à la caractérisation d'une accélération dans l'espace et donc à la réalisation d'un accéléromètre à trois dimensions.

Le capot peut être simplement collé sur des billes qui le maintiennent à distance de l'organe. Avantageusement néanmoins, le capot et l'organe sont reliés par un procédé d'interconnexion au moyen de billes en matériau fusible selon la technique de "Flip-Chip". Ces billes peuvent être également des galettes de matériau fusible.

Grâce à l'invention, les billes d'interconnexion peuvent être conformes au savoir faire standard. Effectivement, dans le capteur conforme à l'invention, les billes assurent le maintien mécanique du capot et éventuellement de contact électrique mais ne servent pas à définir le second espacement entre le capot et l'organe de caractérisation. Cet espacement est défini par l'épaisseur du bossage du capot qui est situé en regard de l'organe de caractérisation.

Les billes ou plus généralement les billes permettent par contre de définir le premier espacement entre le capot et le substrat.

De plus si le bossage est suffisamment épais, les billes peuvent être de grande taille et par conséquent permettent de palier au problème lié aux contraintes mécaniques liées à un éventuel différentiel des coefficients de dilatation. Des billes plus grandes permettent également une réalisation plus aisée.

Selon une autre caractéristique intéressante de l'invention, le capot est formé par un substrat comportant un circuit électronique de lecture.

Le capot et le substrat sont pourvus de plots d'interconnexion auxquels l'organe de caractérisation et le circuit électronique de lecture sont respectivement reliés. Ces plots servent au dépôt des billes pour l'interconnexion et assurent, avec les billes la connexion électrique entre l'organe de caractérisation et le circuit électronique.

L'invention concerne également un procédé de réalisation d'un capteur.

D'autres caractéristiques et avantages de l'invention ressortiront mieux de la description qui va suivre, donnée à titre purement illustratif et non limitatif, en référence aux figures annexées, dans lesquelles :
- la figure 1 est une vue schématique en coupe d'un capteur selon l'invention,
- les figures 2A et 2B sont des vues schématiques de dessus et en coupe selon la ligne A-A du substrat gravé comportant la masse sismique du capteur de l'invention,
- la figure 3 est une vue en coupe de différentes étapes de réalisation d'un capteur selon l'invention.

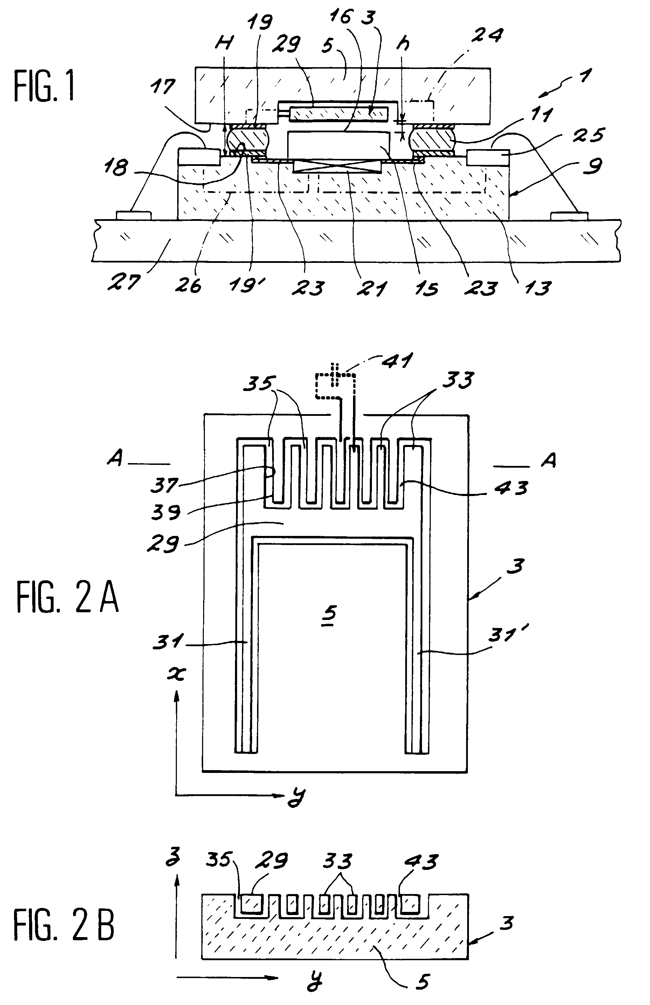

Comme on peut le voir à la figure 1, le capteur 1 comporte un substrat 5 présentant un organe de caractérisation 3 obtenu par des techniques de micro-usinage. Le substrat 5 est relié à un capot 9 au moyen de billes d'interconnexion 11 situées de part et d'autre de l'organe de caractérisation 3. Ces billes constituent une bille permettant de maintenir le capot 9 à une distance H du substrat 5.

Le capot 9 est lui-même composé d'un substrat 13, préférentiellement en un matériau isolant ou semi-conducteur et d'un bossage 15 formé sur le substrat 13 dans la région faisant face à l'organe de caractérisation 3. Ce bossage 15 permet de réduire et de définir avec précision par rapport à l'art antérieur l'espacement h entre le capot 9 et l'organe de caractérisation 3. Cet espacement h est bien inférieur à l'espacement H entre le substrat 5 de l'organe de caractérisation et le substrat 13 du capot 9, c'est-à-dire dans la région entourant le bossage 15.

Le capot 9 et le substrat 5 de l'organe 3 sont pourvus sur leurs surfaces 18 et 17 en regard, dans la région entourant le bossage 15 et l'organe de caractérisation 3, de plots d'interconnexion 19, 19'. Ces plots 19, 19' permettent l'accrochage des billes 11 et un bon contact électrique pour celles-ci.

Ces billes sont mises à profit pour relier l'organe de caractérisation 3 à un circuit électronique 21 réalisé dans le substrat 13 du capot 9, par exemple sous le bossage 15.

Pour éviter les problèmes de contraintes thermomécaniques déjà évoqués, l'espacement H (hauteur des billes) est choisi suffisant par rapport à la taille de la puce (substrat). De façon typique on choisit H>10⁻²xD, où D est la taille ou la plus grande dimension de la puce (substrat). A titre d'exemple H≥45 µm pour un substrat 5 de 4x4mm. Dans ce cas, on définit le bossage 15 avec une épaisseur de 40 µm afin d'avoir un espacement h entre le capot et l'organe de caractérisation calibré de 5 µm.

Des amenées de courant 23 et 24 formées respectivement sur le substrat 13 et le substrat 5 relient l'organe de caractérisation 3 et le circuit électronique 21 aux billes 11, via les plots 19 et 19'. Dans cet exemple, les amenées 24 sont intégrées dans le substrat 5.

Le circuit électronique 21 est relié, via des pistes 26 intégrées dans le substrat 13, à des plots de contact extérieurs 25 formés sur la surface 18 du capot. Ces plots 25 sont eux-mêmes reliés par exemple à des pistes d'un circuit imprimé 27 sur lequel est monté le capteur, via le capot.

Dans le cas d'un accéléromètre, l'organe de caractérisation 3 peut comporter comme le montrent les figures 2A et 2B une masse sismique 29 de forme parallélépipédique dans le plan (x,y) de la surface du substrat, qui est le plan de la figure 2A.

La masse sismique 29 est reliée au substrat 5 par deux poutres 31, 31' flexibles et est pourvue, dans la direction opposée à celle des poutres, de dents 33 s'étendant librement dans des gorges 35 pratiquées dans le substrat.

La masse 29 est prévue pour pouvoir se déplacer selon la direction y parallèle au plan x,y du substrat.

Des parties latérales 37, 39, selon la direction x, des dents 33 de la masse sismique 29 et des gorges 35, sont respectivement recouvertes d'une couche métallique et/ou sont elles-mêmes de nature conductrice, par exemple en silicium dopé, formant les armatures d'un condensateur 41 de capacité variable. Sous l'effet d'une accélération, la masse sismique 29 se déplace et l'épaisseur d'une couche d'air 43 située dans les interstices entre les parties 37, 39 est modifiée. Cette couche d'air 43 constituant le diélectrique du condensateur, la valeur de la capacité mesurée sur les armatures est également modifiée.

La figure 2B illustre le mouvement de la masse sismique selon la direction y, au niveau des dents 33.

Il est nécessaire de veiller à ce qu'une accélération selon la direction z perpendiculaire à la surface du substrat, c'est-à-dire au plan x,y, ne provoque pas de mouvement de la masse sismique, d'amplitude supérieure à la profondeur des gorges dans lesquelles sont logées les dents afin de ne pas les déchausser.

Il faut par ailleurs protéger la masse sismique d'un mouvement excessif qui dépasse la limite élastique des poutres 31, 31'. Une butée doit donc être prévue à une distance du même ordre de grandeur que la profondeur des gorges 35, soit de 5 à 20 µm.

Le mouvement selon l'axe z est, conformément à l'invention, limité par le bossage 15 pourvu d'une surface de butée 16.

Ce bossage 15 doit pour cela être situé à un espacement h de la surface du substrat 5 allant de préférence de 0,5 à 5 µm.

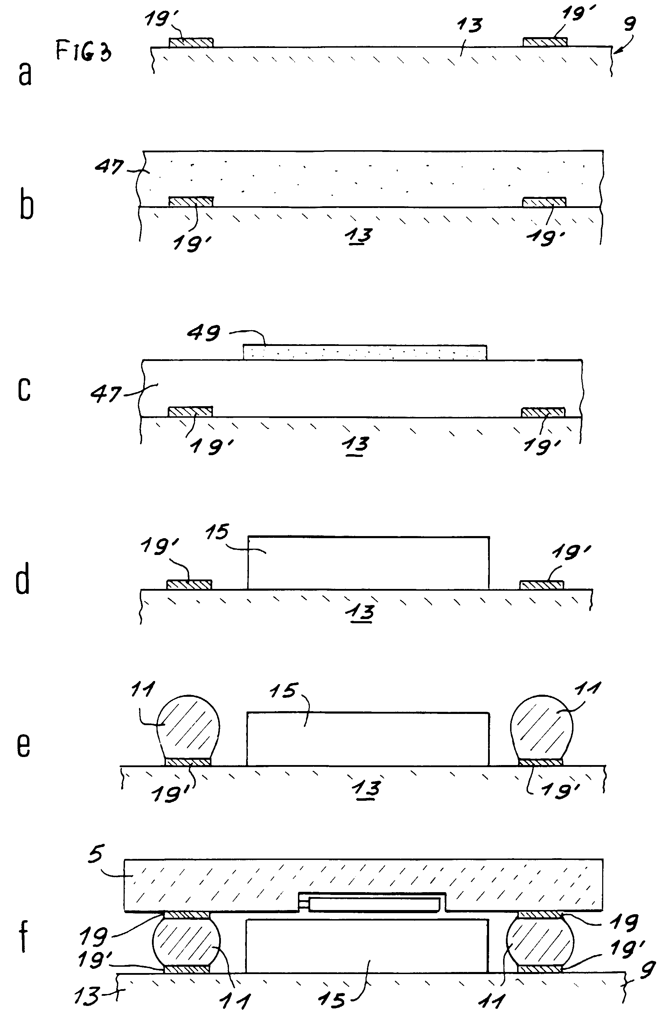

La figure 3 illustre, en coupe, un procédé de réalisation du capteur selon l'invention.

On réalise tout d'abord un ou de préférence plusieurs plots d'interconnexion 19' et 19 respectivement sur le substrat 13 du capot 9 et sur le substrat 5 de l'organe 3 (parties a et f), par exemple par évaporation d'un matériau conducteur à travers un masque. Ce matériau doit être mouillant par rapport au matériau constituant les billes 11.

Les plots 19' sont disposés sur la face 18 du capot 9 qui sera amenée vers le substrat 5 comportant l'organe de caractérisation 3 lors de l'assemblage. Les plots 19 du substrat 5 sont réalisés à côté de l'organe de caractérisation 3, de part et d'autre de celui-ci.

Les plots 19 et 19' seront par exemple en or ou en argent et les billes 11 en alliage d'étain et de plomb ou d'indium ou tout autre alliage fusible.

Les plots du capot et du substrat sont disposés de manière à se faire respectivement face lors de l'assemblage.

Sur le substrat 13 équipé de ses plots d'interconnexion 19', on dépose une couche 47 de matériau isolant ou éventuellement semi-conducteur (partie b). Comme cette couche sert à la formation du bossage, il est nécessaire de contrôler soigneusement son épaisseur. De préférence, on utilise une couche de polyimide photosensible ou non dont on peut contrôler facilement l'épaisseur dans la gamme d'environ 10 à 40 µm, notamment selon un procédé dit de "dépôt à la tournette".

Après la réalisation d'un masque 49 selon les techniques de photolithographie sur la couche 47 (partie c), on la grave de manière à délimiter le bossage 15 et à mettre à nu les plots 19' d'interconnexion (partie d). La gravure de la couche 47 de polyimide peut se faire par plasma d'oxygène ou attaque chimique humide lorsque le polyimide n'est pas photosensible.

Le masque est également éliminé et on forme sur les plots d'interconnexion 19' des billes 11 de matériau fusible (partie e) . Ces billes 11 sont déposées par des techniques courantes d'évaporation sous vide ou par électrolyse.

Dans une autre étape (partie f), on rapporte le substrat 5 sur le substrat 13. Cette opération a lieu à une température légèrement supérieure à la température de fusion des billes afin de rendre solidaires les deux substrats.

Selon des variantes de réalisation, il est possible de rapporter le capot sur le substrat de l'organe de caractérisation ou le substrat de l'organe de caractérisation sur le capot. De même, les billes d'interconnexion peuvent être réalisées soit sur les plots du capot, soit sur ceux du substrat de l'organe de caractérisation.

Lorsque l'organe de caractérisation est très sensible, il peut être préférable de réaliser les billes d'interconnexion sur le capot.

Finalement, grâce à l'invention, en associant un bossage par exemple en polyimide, dont l'épaisseur est contrôlée avec précision, à l'usage de billes de connexion adaptées à la taille de la puce ou du substrat du capteur, on peut obtenir à la fois un espacement 4 bien calibré au micromètre près entre le capot et l'organe de caractérisation, et une excellente fiabilité du capteur.

## Revendications

1. Capteur électronique intégré destiné à la caractérisation d'une grandeur physique, comprenant un substrat (5) comportant un organe de caractérisation (3) dont une partie est apte à se déformer selon au moins une direction (y, z) et un capot maintenu à proximité et face à l'organe de caractérisation (3) au moyen d'au moins une bille en matériau fusible (11) solidaire du substrat (5) de hauteur adaptée aux contraintes thermomécaniques du capteur, un premier espacement (H) étant ainsi ménagé entre le capot (9) et le substrat, caractérisé en ce que le capot (9) comporte un bossage (15) d'épaisseur contrôlée en regard de l'organe de caractérisation (3) de manière à définir un second espacement (h) entre le capot et l'organe (3), plus petit que l'espacement entre le capot et le substrat.

2. Capteur selon la revendication 1, caractérisé en ce que le bossage (15) présente une surface (16) de butée pour l'organe de caractérisation.

3. Capteur selon la revendication 2, caractérisé en ce que la surface de butée (16) est parallèle à ladite direction (y).

4. Capteur selon la revendication 2, caractérisé en ce que la surface de butée (16) est sensiblement perpendiculaire à ladite direction (z).

5. Capteur selon l'une des revendications précédentes, caractérisé en ce que le bossage (15) est réalisé en un matériau conducteur électrique.

6. Capteur selon l'une des revendications 1 à 4, caractérisé en ce que le bossage (15) comporte une partie en matériau conducteur électrique, ladite partie formant la surface de butée.

7. Capteur selon l'une des revendications 5 ou 6, caractérisé en ce que le bossage forme (15) une électrode coopérant avec l'organe de caractérisation (3).

8. Capteur selon la revendication 7, caractérisé en ce qu'un accéléromètre à trois dimensions est réalisé avec le bossage (3) comme électrode.

9. Capteur selon l'une des revendications précédentes, caractérisé en ce que le second espacement (h) entre le capot (9) et l'organe de caractérisation (3) est au maximum égal à la course autorisée avant rupture de l'organe de caractérisation (3).

10. Capteur selon l'une des revendications précédentes, caractérisé en ce que le second espacement (h) entre le capot et l'organe de caractérisation est compris entre 0,5 µm et 5 µm.

11. Capteur selon l'une quelconque des revendications précédentes, caractérisé en ce que l'espacement (H) ménagé entre le capot (9) et le substrat (5) est tel que H>10⁻².D où D est une plus grande dimension du substrat.

12. Capteur selon l'une quelconque des revendications précédentes, caractérisé en ce que la bille (11) est en matériau fusible.

13. Capteur selon l'une des revendications précédentes, caractérisé en ce que le capot (9) comporte un circuit électronique intégré (21) relié électriquement à l'organe de caractérisation (3) à l'aide d'une liaison électrique (23, 24, 19, 11, 19').

14. Capteur selon la revendication 13, caractérisé en ce que la liaison électrique (23, 24, 19, 11, 19') comprend la bille (11).

15. Capteur selon la revendication 13 ou 14, caractérisé en ce que le capot (9) et le substrat (5) comportent chacun au moins un plot d'interconnexion (19, 19') connecté respectivement au circuit électronique (21) et à l'organe de caractérisation (3), lesdits plots (19, 19') étant reliés entre-eux au moyen de la bille.

16. Capteur selon l'une quelconque des revendications précédentes, caractérisé en ce que l'organe de caractérisation (3) comporte une masse sismique (29) formée parallèlement à une surface du substrat (5) et selon un plan (x,y) contenant ladite direction (y) et dont une partie (37) constitue une armature d'un condensateur (41).

17. Capteur selon la revendication 15, caractérisé en ce que la masse sismique (29) est de forme parallélépipédique et équipée de dents (33) aptes à se déplacer dans des gorges (35) pratiquées dans le substrat (5).

18. Procédé de réalisation d'un capteur conforme à l'une quelconque des revendications 15 à 17, caractérisé en ce qu'il comprend successivement les étapes suivantes :
- réalisation d'au moins un premier plot (19) d'interconnexion sur le substrat (5) à côté de l'organe de caractérisation (3) et au moins un second plot (19') sur une surface (18) du capot (9), tournée. vers l'organe de caractérisation (3), le premier et le second plots (19, 19') étant disposés de manière à être en regard lorsque le substrat (5) et le capot (9) sont solidaires ;
- formation localement sur la face (18) du capot (9) d'une couche (47) d'épaisseur contrôlée, constituant le bossage ;
- dépôt sur l'un des plots (19, 19') en regard, de la bille sous forme de matériau fusible ;
- solidarisation et interconnexion du capot (9) et du substrat (5) par fusion du matériau fusible.

19. Procédé selon la revendicatin 18, caractérisé en ce que la couche (47) d'épaisseur contrôlée est une couche de polyimide.

## Patentansprüche

1. Integrierter elektronischer Sensor zur Charakterisierung einer physikalischen Größe, ein Substrat (5) umfassend, das ein Charakterisierungselement (3) enthält, von dem ein Teil fähig ist, sich in wenigstens einer Richtung (x, z) zu verformen, und eine Kappe, dem Charakterisierungselement (3) nahe und gegenüber festgehalten durch wenigstens eine Kugel aus schmelzbarem Material (11), fest mit dem Substrat (5) verbunden mit den thermomechanischen Beanspruchungen des Sensors angepaßter Höhe, wobei somit ein erster Abstand (H) zwischen der Kappe (9) und dem Substrat hergestellt ist,
**dadurch gekennzeichnet**,
daß die Kappe (9) einen Höcker (15) von kontrollierter Dicke umfaßt, dem Charakterisierungselement (3) gegenüberstehend, um einen zweiten Abstand (h) zwischen der Kappe und dem Element (3) zu definieren, der kleiner ist als der Abstand zwischen der Kappe und dem Substrat.

2. Sensor nach Anspruch 1, dadurch gekennzeichnet, daß der Höcker (15) eine Anschlagfläche (16) für das Charakterisierungselement aufweist.

3. Sensor nach Anspruch 2, dadurch gekennzeichnet, daß die Anschlagfläche (16) parallel ist zu der genannten Richtung (y).

4. Sensor nach Anspruch 2, dadurch gekennzeichnet, daß die Anschlagsfläche (16) im wesentlichen parallel ist zu der genannten Richtung (z).

5. Sensor nach einem der vorangehenden Ansprüche, dadurch gekennzeichnet, daß der Höcker (15) aus einem elektrisch leitenden Material hergestellt ist.

6. Sensor nach einem der Ansprüche 1 bis 4, dadurch gekennzeichnet, daß der Höcker (15) einen Teil aus einem elektrisch leitenden Material umfaßt, wobei dieser Teil die Anschlagfläche bildet.

7. Sensor nach einem der Ansprüche 5 oder 6, dadurch gekennzeichnet, daß der Höcker (15) eine mit dem Charakterisierungselement (3) zusammenwirkende Elektrode bildet.

8. Sensor nach Anspruch 7, dadurch gekennzeichnet, daß ein dreidimensionaler Beschleunigungsmesser mit dem Höcker (15) als Elektrode hergestellt wird.

9. Sensor nach einem der vorangehenden Ansprüche, dadurch gekennzeichnet, daß der zweite Abstand (h) zwischen der Kappe (9) und dem Charakterisierungselement (3) höchstens gleich dem zulässigen Ausschlag vor Brechen des Charakterisierungselements (3) ist.

10. Sensor nach einem der vorangehenden Ansprüche, dadurch gekennzeichnet, daß der zweite Abstand (h) zwischen der Kappe und dem Charakterisierungselement zwischen 0,5µm und 5µm enthalten ist.

11. Sensor nach einem der vorangehenden Ansprüche, dadurch gekennzeichnet, daß der Abstand (H) zwischen der Kappe (9) und dem Substrat (5) derart ist, daß H>10⁻².D, wobei D eine größte Abmessung des Substrats ist.

12. Sensor nach einem der vorangehenden Ansprüche, dadurch gekennzeichnet, daß die Kugel (11) aus einem schmelzbaren Material ist.

13. Sensor nach einem der vorangehenden Ansprüche, dadurch gekennzeichnet, daß die Kappe (9) eine integrierte elektronische Schaltung (21) umfaßt, elektrisch verbunden mit dem Charakterisierungselement (3) mit Hilfe einer elektrischen Verbindung (23, 24, 19, 11, 19').

14. Sensor nach Anspruch 13, dadurch gekennzeichnet, daß die elektrische Verbindung (23, 24, 19, 11, 19') die Kugel (11) umfaßt.

15. Sensor nach Anspruch 13 oder 14, dadurch gekennzeichnet, daß die Kappe (9) sowie das Substrat (5) wenigstens ein Zwischenverbindungs-Kontaktklötzchen (19, 19') umfassen, jeweils verbunden mit der elektronischen Schaltung (21) und dem Charakterisierungselement (3), wobei besagte Kontaktklötzchen (19, 19') durch die Kugel miteinander verbunden sind.

16. Sensor nach einem der vorangehenden Ansprüche, dadurch gekennzeichnet, daß das Charakterisierungselement (3) eine seismische Masse (29) umfaßt, ausgebildet parallel zu einer Fläche des Substrats (5) und entsprechend einer die besagte Richtung (y) enthaltend Ebene (x,y) und von der ein Teil (37) eine Belegung eines Kondensators (41) bildet.

17. Sensor nach Anspruch 15, dadurch gekennzeichnet, daß die seismische Masse (29) von parallelflacher Form ist und mit Zähnen (33) versehen ist, die sich in den Aussparungen (35) bewegen können, die in dem Substrat (5) vorgesehen sind.

18. Herstellungsverfahren eines Sensors nach einem der Ansprüche 15 bis 17, dadurch gekennzeichnet, daß es folgende aufeinanderfolgende Schritte umfaßt:
- Herstellung wenigstens eines ersten Zwischenverbindungs-Kontaktklötzchens (19) auf dem Substrat (5) neben dem Charakterisierungselement (3) und wenigstens eines zweiten Kontaktklötzchens (19') auf einer Fläche (18) der Kappe (9), dem Charakterisierungselement (3) zugekehrt, wobei das erste und das zweite Kontaktklötzchen (19, 19') so angeordnet sind, daß sie sich gegenüberstehen, wenn das Substrat (5) und die Kappe (9) fest verbunden sind;
- lokale Bildung einer Schicht (47) von kontrollierter Dicke auf der Fläche (18) der Kappe (9), die den Höcker bildet;
- Abscheidung der Kugel in Form eines schmelzbaren Materials auf einem der gegenüberstehenden Kontaktklötzchen (19, 19');
- gegenseitige Befestigung und Verbindung der Kappe (9) und des Substrats (5) durch Schmelzen des schmelzbaren Materials.

19. Verfahren nach Anspruch 18, dadurch gekennzeichnet, daß die Schicht (47) mit kontrollierter Dicke eine Polyimidschicht ist.

## Claims

1. Integrated electronic sensor for characterizing in a physical quantity, incorporating a substrate (5) having a characterizing member (3), whereof part is able to deform in at least one direction (y,z), and a cover maintained in the vicinity of and in front of the characterizing member (3) by means of at least one meltable material ball (11) integral with the substrate (5) and having a height adapted to the thermomechanical stresses of the sensor, so that a first spacing (H) is provided between the cover (9) and the substrate, characterized in that the cover (9) has a boss (15) with a controlled thickness facing the characterizing member (3), so as to define a second spacing (h) between the cover and the member (3) which is smaller than the spacing between the cover and the substrate.

2. Sensor according to claim 1, characterized in that the boss (15) has an abutment surface (16) for the characterizing member.

3. Sensor according to claim 2, characterized in that the abutment surface (16) is parallel to said direction (y).

4. Sensor according to claim 2, characterized in that the abutment surface (16) is substantially perpendicular to said direction (z).

5. Sensor according to one of the preceding claims, characterized in that the boss (15) is made from an electrically conductive material.

6. Sensor according to one of the claims 1 to 4, characterized in that the boss (15) has an electrically conductive material part, which forms the abutment surface.

7. Sensor according to one of the claims 5 or 6, characterized in that the boss (15) forms an electrode cooperating with the characterizing member (3).

8. Sensor according to claim 7, characterized in that a three-dimensional accelerometer is produced with the boss (3) serving as the electrode.

9. Sensor according to one of the preceding claims, characterized in that the second spacing (h) between the cover (9) and the characterizing member (3) has a maximum equal to the authorized travel prior to the breaking of the characterizing member (3).

10. Sensor according to one of the preceding claims, characterized in that the second spacing (h) between the cover and the characterizing member is between 0.5 µm and 5 µm.

11. Sensor according to one of the preceding claims, characterized in that the spacing (H) between the cover (9) and the substrate (5) is such that H→10⁻²D, in which D is a largest dimension of the substrate.

12. Sensor according to one of the preceding claims, characterized in that the ball (11) is of meltable material.

13. Sensor according to one of the preceding claims, characterized in that the cover (9) has an electronic integrated circuit (21) electrically connected to the characterizing member (3) with the aid of an electrical connection (23, 24, 19, 11, 19').

14. Sensor according to claim 13, characterized in that the electrical connection (23, 24, 19, 11, 19') comprises the ball (11).

15. Sensor according to claim 13 or 14, characterized in that both the cover (9) and the substrate (5) has at least one interconnection element (19, 19') respectively connected to the electronic circuit (21) and the characterizing member (3), said elements (19, 19') being interconnected by means of the ball.

16. Sensor according to one of the preceding claims, characterized in that the characterizing member (3) incorporates a seismic mass (29) formed parallel to a surface of the substrate (5) and in accordance with a plane (x, y) containing said direction (y) and whereof a portion (37) constitutes a plate of a capacitor (41).

17. Sensor according to claim 15, characterized in that the seismic mass (29) is parallelepipedic and equipped with teeth (33) able to move into grooves (35) made in the substrate (5).

18. Process for the production of a sensor according to any one of the claims 15 to 17, characterized in that it successively comprises the following stages:
- producing at least one first interconnection element (19) on the substrate (5) alongside the characterizing member (3) and at least one second element (19') on a face (18) of the cover (9) turned towards the characterizing member (3), the first and second elements (19, 19') being arranged so as to face one another when the substrate (5) and cover (9) are integral,
- formation locally on the face (18) of the cover (9) of a controlled thickness coating (47) constituting the boss,
- deposition on one of the facing elements (19, 19') of the meltable material ball,
- joining and interconnecting the cover (9) and the substrate (5) by melting the meltable material.

19. Process according to claim 18, characterized in that the controlled thickness coating (47) is a polyimide coating.
